# EUROPEAN PATENT APPLICATION

(11) **EP 4 645 694 A1**
(43) Date of publication of application: **05.11.2025**
(21) Application number: 25170304.7
(22) Date of filing: 14.04.2025
(51) Int. Cl.: H03H 9/02, H03H 9/17, H03H 9/54

(54) **RESONATOR DEVICES WITH REVERSE POLARIZED LAYERS**

(30) Priority: 29.04.2024 US 202418649883
(71) Applicant: Avago Technologies International Sales Pte. Limited, Singapore 768923 (SG)
(72) Inventor: Ivira, Brice, San Jose, CA, 95131 (US); Ruby, Richard C., Menlo Park, CA, 94025 (US); Kirkendall, Chris, Morgan Hill, CA, 95037 (US)
(74) Representative: Grünecker Patent- und Rechtsanwälte PartG mbB

(57) **Abstract**

An example resonator device (100) includes a first electrode (110), a second electrode (120), a first piezoelectric film (144) disposed between the first electrode (110) and the second electrode (120), and a second piezoelectric film (142) disposed between the first piezoelectric film (144) and the first electrode (110). The first piezoelectric film (144) has a first polarization in a first orientation, the second piezoelectric film (142) has a second polarization in a second orientation, and the second orientation is opposite of the first orientation.

## Description

### BACKGROUND

The present disclosure relates, in general, to resonator devices for use in various types of electronic circuits and electronic devices. For example, resonator devices can be used in various filtering applications pertaining to different types of signals, including filters for radio frequency (RF) signals and other types of signals. Advancements in resonator device technology including bulk acoustic wave (BAW) resonator devices are desired in various applications.

### BRIEF DESCRIPTION OF THE DRAWINGS

FIG. 1 shows a cross section of an example resonator device with two piezoelectric film layers, in accordance with some aspects of the disclosure.
FIG. 2 shows a cross section of another example resonator device with two piezoelectric film layers, in accordance with some aspects of the disclosure.
FIG. 3 shows a cross section of an example resonator device with three piezoelectric film layers, in accordance with some aspects of the disclosure.
FIG. 4 shows a cross section of another example resonator device with three piezoelectric film layers, in accordance with some aspects of the disclosure.
FIG. 5 shows a cross section of an example resonator device with four piezoelectric film layers, in accordance with some aspects of the disclosure.
FIG. 6 shows a cross section of another example resonator device with four piezoelectric film layers, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

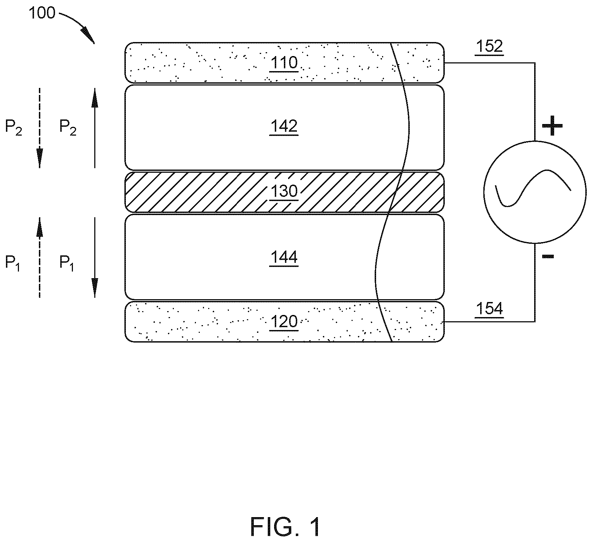

Referring to FIG. 1, a cross section illustrating an example resonator device 100 is shown, in accordance with some aspects of the disclosure. The resonator device 100 generally is similar to a thin-film bulk acoustic resonator (FBAR) device and can be used, for example, in a variety of electronic circuits and electronic devices for BAW applications (e.g., RF filters, duplexers, RF power amplifiers, RF receiver modules, etc.). However, relative to a typical FBAR device, the resonator device 100 includes two piezoelectric film layers instead of one piezoelectric film layer. Accordingly, the resonator device 100 can be considered the second thickness extensional (TE2) mode with a polarization-switched bulk acoustic resonator device that includes a stack of layers. As illustrated in FIG. 1, the resonator device 100 includes a top electrode 110, a bottom electrode 120, a middle material 130, a piezoelectric film 142, and a piezoelectric film 144. The top electrode 110 can be coupled to an input signal 152 (e.g., an RF signal, etc.), and the bottom electrode 120 can then be coupled to a reference voltage 154 (i.e., the bottom electrode 120 can be grounded). These connections can also be reversed such that the top electrode 110 can be coupled to the reference voltage 154 and the bottom electrode 120 can be coupled to the input signal 152.

The top electrode 110 and the bottom electrode 120 can be formed using various suitable materials depending on the application. For example, the top electrode 110 can be formed using suitable metals such as, for example, aluminum, copper, molybdenum, tungsten, platinum, iridium, and/or other suitable metals. The bottom electrode 120 can likewise be formed using suitable metals such as, for example, aluminum, copper, molybdenum, tungsten, platinum, iridium, and/or other suitable metals. The top electrode 110 and/or the bottom electrode 120 can also be formed using lighter materials in some applications such as, for example, materials that are not necessarily metals. Notably, relative to alternative structures, only the bottom electrode 120 is grounded, and the top electrode 110 is coupled to the input signal 152 (or the reverse). Due to this configuration, the piezoelectric film 142 and the piezoelectric film 144 are not connected in parallel, but in series. To keep a similar impedance as an FBAR device, the active area of the resonator device 100 is nearly doubled compared to an FBAR device, and the TE2 stack can cancel the second harmonics completely at the condition the stack is symmetric, and one piezoelectric layer has the polarization reversed compared to the other piezoelectric layer.

The middle material 130 can also be formed using various suitable materials depending on the application. For example, the middle material 130 can be a middle electrode formed using suitable metals such as aluminum, copper, molybdenum, tungsten, platinum, iridium, and/or other suitable metals. The middle material 130 can also be formed using lighter materials (including non-metals) in some applications. The middle material 130 is disposed between the piezoelectric film 142 and the piezoelectric film 144, and the middle material 130 can be constructed such that the middle material 130 does not acoustically decouple the piezoelectric film 142 and the piezoelectric film 144 (e.g., like in a coupled resonator filter (CRF) where decoupling layer(s) are included between piezoelectric layer(s)). Instead, the piezoelectric film 142 and the piezoelectric film 144 can be tightly coupled acoustically to form a single resonator device with one series resonance and one parallel resonance. The composition and the thickness of the middle material 130 can be adjusted to ensure that the resonator device 100 has a Type II response.

In filtering applications, when using a Type I resonator device, the output signal can include rattles and/or other noise artifacts present at a frequency above the resonant frequency (Fₛ). This noise above Fₛ can be a significant drawback for filters where high energy modes land from mid-band to the high-band edge, where self-heating is most critical. Moreover, the noise above Fₛ can degrade linear performance on the upper band. However, when using a Type II resonator device, the output signal can include rattles and/or other noise artifacts that are present at a frequency below Fₛ. The noise below Fₛ can be much less critical for filtering applications, where linear and large signal response are improved. Accordingly, because the inclusion of the middle material 130 in the structure of the resonator device 100 can make the resonator device a Type II resonator device, the inclusion of the middle material 130 in the structure of the resonator device 100 can improve the performance of the resonator device 100 in many filtering applications.

The piezoelectric film 142 and the piezoelectric film 144 can be formed using various suitable piezoelectric materials depending on the application. For example, the piezoelectric film 142 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 144 can be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 144 has a first polarity P₁ and the piezoelectric film 142 has a second polarity P₂. The first polarity is in a first orientation and the second polarity is in a second orientation, and the first orientation is opposite the second orientation. The first polarity and the second polarity can be created in the piezoelectric film 142 and the piezoelectric film 144, respectively, by doping the piezoelectric film 142 and/or the piezoelectric film 144 with a dopant. In the resonator device 100, the dipole moment of the piezoelectric film 142 and the dipole moment of the piezoelectric film 144 can generally be reversed relative to each other.

For example, the piezoelectric film 144 can be deposited on the bottom electrode 120 as either N-polar or M-polar. The piezoelectric film 142 can then be deposited in the same manner as the piezoelectric film 144 on the middle material 130 such that the piezoelectric film 142 initially is polarized in the same orientation as the piezoelectric film 144. However, then the piezoelectric film 142 can be doped with a suitable dopant to reverse the polarization of the piezoelectric film 142 relative to the piezoelectric film 144 (e.g., to be M-polar if the piezoelectric film 144 is N-polar, to be N-polar if the piezoelectric film 144 is M-polar, etc.). The dopant can be any of a variety of suitable dopants, such as, for example, silicon, germanium, magnesium, copper, aluminum, a combination of silicon and magnesium, a combination of magnesium with one or more additional elements, and/or other suitable dopants. The piezoelectric film 144 can be disposed between the top electrode 110 and the bottom electrode 120, and the piezoelectric film 142 can be disposed between the piezoelectric film 144 and the top electrode 110. In some applications, the piezoelectric film 144 can be doped with the dopant instead of the piezoelectric film 142. Also, in some applications, both the piezoelectric film 142 and the piezoelectric film 144 can be doped with suitable dopants to induce the reversed polarity of the piezoelectric film 142 and the piezoelectric film 144.

In some alternative approaches, reversed polarity of the piezoelectric film 142 and the piezoelectric film 144 can be induced by applying an external electrical field (e.g., DC field) across one of the piezoelectric film 142 or the piezoelectric film 144. However, this approach has some drawbacks due to the polarization being clamped in the grain boundaries (joints) and defects (e.g., vacancy, atom interstitial). Thus, the polarities may be unable to be switched entirely. Moreover, in a large wafer, it may be impractical to flip the polarization of all resonators in this manner without experiencing some level of performance degradation due to residual effects. However, by flipping the polarities using doping as in the resonator device 100, advantages relative to the external electrical field approach can be provided. For example, a more reliable polarity reversing can be provided because polarity can be reversed in all domains, and thus a better homogeneity of the reversed films can be provided across a large wafer. Further, since no external electrical field needs to be provided, the middle material 130 can be formed using materials besides metals, such as discussed above, including materials with a positive temperature compensation.

Moreover, in many resonator applications, the resonant frequency (Fₛ) is inversely proportional to the thickness of the layers of the resonator device. As a result, for higher frequency applications, the thickness of the layers of the resonator device need to get smaller and smaller. For high frequency applications involving frequencies of 7-8 GHz or higher, a more traditional FBAR device including only one piezoelectric film layer would need to be so thin, and the overall area of the device would need to be so small, that the device cannot practically be used in these applications. When considering even higher frequency applications such as satellite applications involving frequencies in the 12-18 GHz range, more traditional FBAR devices become even less practical. However, the resonator device 100 can provide around twice the frequency of a single piezoelectric layer FBAR device with around the same active stack thickness. The resonator device 100 can operate at high frequencies (e.g., above 10 GHz) with very good resistive loss, and the resonator device 100 can cancel the undesired Tₙ₋ₘ and Tₙ₊ₘ modes (e.g., the closest TE1 and/or TE3 modes), thereby leaving only the TE2 (n=2) mode of interest. Additionally, the TE1 mode common in FBAR devices for lower frequency applications can be eliminated by using the resonator device 100.

Additionally, the piezoelectric film 142 and the piezoelectric film 144 can be symmetric (e.g., the same composition and thickness as measured between adjacent piezoelectric layers in the stack) or asymmetric (e.g., different composition such as thickness and/or material properties such as acoustic velocity, piezoelectric constant, etc.) as long as they satisfy the condition that the polarity orientations are reversed relative to each other. In cases where the piezoelectric film 142 and the piezoelectric film 144 are symmetric, the resonator device 100 can advantageously provide only the second overtone (TE2 mode). However, when the piezoelectric film 142 and the piezoelectric film 144 are asymmetric, the resonator device 100 can provide the second overtone and associated advantages, but also may provide residual (parasitic) modes such as TE3 and/or TE1 overtones.

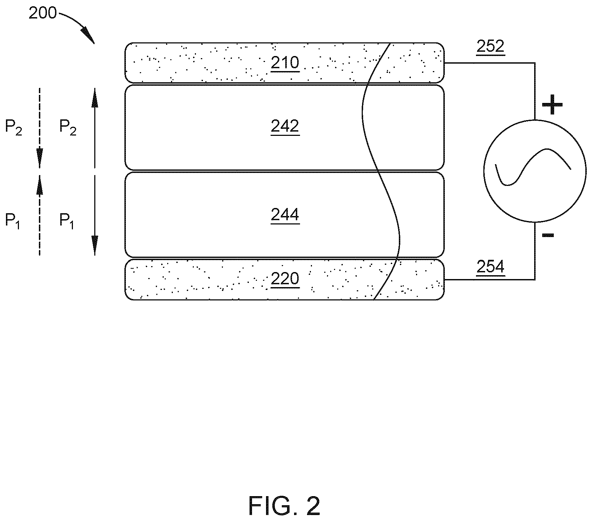

Referring to FIG. 2, a cross section illustrating another example resonator device 200 is shown, in accordance with some aspects of the disclosure. The resonator device 200 generally is similar to the resonator device 100. However, relative to the resonator device 100, the resonator device 200 does not include a middle layer between piezo layers. Due to the absence of the middle layer, the resonator device 200 generally is a Type I resonator device instead of a Type II resonator device, and can provide advantages in different applications. The resonator device 200 can also be considered a TE2 device that includes a stack of layers. As illustrated in FIG. 2, the resonator device 200 includes a top electrode 210, a bottom electrode 220, a piezoelectric film 242, and a piezoelectric film 244. The top electrode 210 can be coupled to an input signal 252 (e.g., an RF signal, etc.), and the bottom electrode 220 can then be coupled to a reference voltage 254 (i.e., the bottom electrode 220 can be grounded). These connections can also be reversed such that the top electrode 210 can be coupled to the reference voltage 254 and the bottom electrode 220 can be coupled to the input signal 252.

The top electrode 210 and the bottom electrode 220 can be formed using various suitable materials depending on the application. For example, the top electrode 210 can be formed using suitable metals such as, for example, aluminum, copper, molybdenum, tungsten, platinum, iridium, and/or other suitable metals. The bottom electrode 220 can likewise be formed using suitable metals such as, for example, aluminum, copper, molybdenum, tungsten, platinum, iridium, and/or other suitable metals. The top electrode 210 and/or the bottom electrode 220 can also be formed using lighter materials in some applications such as, for example, materials that are not necessarily metals. Notably, relative to alternative structures, only the bottom electrode 220 is grounded, and the top electrode 210 is coupled to the input signal 252 (or the reverse). Due to this configuration, the piezoelectric film 242 and the piezoelectric film 244 are not connected in parallel, but in series.

The piezoelectric film 242 and the piezoelectric film 244 can be formed using various suitable piezoelectric materials depending on the application. For example, the piezoelectric film 142 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 244 can be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 244 has a first polarity P₁ and the piezoelectric film 242 has a second polarity P₂. The first polarity is in a first orientation and the second polarity is in a second orientation, and the first orientation is opposite the second orientation. The first polarity and the second polarity can be created in the piezoelectric film 242 and the piezoelectric film 244, respectively, by doping the piezoelectric film 242 and/or the piezoelectric film 244 with a dopant. In the resonator device 200, the dipole moment of the piezoelectric film 242 and the dipole moment of the piezoelectric film 244 can generally be reversed relative to each other.

For example, the piezoelectric film 224 can be deposited on the bottom electrode 220 as either N-polar or M-polar. The piezoelectric film 242 can then be deposited in the same manner as the piezoelectric film 244 on the piezoelectric film 242 such that the piezoelectric film 242 initially is polarized in the same orientation as the piezoelectric film 244. However, then the piezoelectric film 242 can be doped with a suitable dopant to reverse the polarization of the piezoelectric film 242 relative to the piezoelectric film 244 (e.g., to be M-polar if the piezoelectric film 244 is N-polar, to be N-polar if the piezoelectric film 244 is M-polar, etc.). The dopant can be any of a variety of suitable dopants, such as, for example, silicon, germanium, magnesium, copper, aluminum, a combination of silicon and magnesium, a combination of magnesium with one or more additional elements, and/or other suitable dopants. The piezoelectric film 244 can be disposed between the top electrode 210 and the bottom electrode 220, and the piezoelectric film 242 can be disposed between the piezoelectric film 244 and the top electrode 210.

The piezoelectric film 242 and the piezoelectric film 244 can be symmetric (e.g., the same composition and thickness as measured between adjacent piezoelectric layers in the stack) or asymmetric (e.g., different composition such as thickness and/or material properties such as acoustic velocity, piezoelectric constant, etc.) as long as they satisfy the condition that the polarity orientations are reversed relative to each other. In cases where the piezoelectric film 242 and the piezoelectric film 244 are symmetric, the resonator device 200 can advantageously provide only the second overtone (TE2 mode). However, when the piezoelectric film 242 and the piezoelectric film 244 are asymmetric, the resonator device 200 can provide the second overtone and associated advantages, but also may provide residual (parasitic) modes such as TE3 and/or TE1 overtones. Like the resonator device 100, the resonator device 200 can provide around twice the frequency of a single piezoelectric layer FBAR device with around the same active stack thickness.

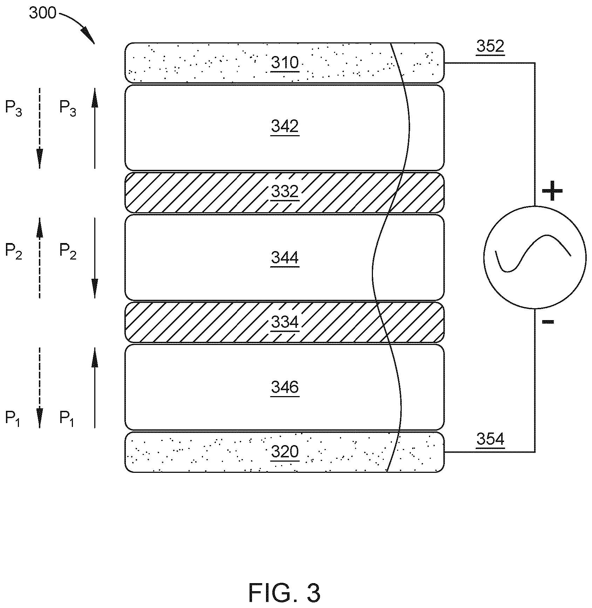

Referring to FIG. 3, a cross section illustrating another example resonator device 300 is shown, in accordance with some aspects of the disclosure. The resonator device 300 generally is similar to the resonator device 100. However, relative to the resonator device 100, the resonator device 300 includes three piezoelectric film layers instead of two piezoelectric film layers to provide added suitability for high frequency applications, for example. Accordingly, the resonator device 300 can be considered the third thickness extensional (TE3) mode with a polarization-switched bulk acoustic resonator device that includes a stack of layers. As illustrated in FIG. 3, the resonator device 300 includes a top electrode 310, a bottom electrode 320, a middle material 332, a middle material 334, a piezoelectric film 342, a piezoelectric film 344, and a piezoelectric film 346. The top electrode 310 can be coupled to an input signal 352 (e.g., an RF signal, etc.), and the bottom electrode 320 can then be coupled to a reference voltage 354 (i.e., the bottom electrode 320 can be grounded). These connections can also be reversed such that the top electrode 310 can be coupled to the reference voltage 354 and the bottom electrode 320 can be coupled to the input signal 352.

The top electrode 310 and the bottom electrode 320 can be formed using various suitable materials depending on the application. For example, the top electrode 310 can be formed using suitable metals such as, for example, aluminum, copper, molybdenum, tungsten, platinum, iridium, and/or other suitable metals. The bottom electrode 320 can likewise be formed using suitable metals such as, for example, aluminum, copper, molybdenum, tungsten, platinum, iridium, and/or other suitable metals. The top electrode 310 and/or the bottom electrode 320 can also be formed using lighter materials in some applications such as, for example, materials that are not necessarily metals. Notably, relative to alternative structures, only the bottom electrode 320 is grounded, and the top electrode 310 is then coupled to the input signal 352 (or the reverse). As a result, the piezoelectric film 342, the piezoelectric film 344, and the piezoelectric film 346 are not connected in parallel, but in series.

The middle material 332 and the middle material 334 can also be formed using various suitable materials depending on the application. For example, the middle material 332 can be a middle electrode formed using various suitable metals such as, for example, aluminum, copper, molybdenum, tungsten, platinum, iridium, and/or other suitable metals. The middle material 332 can also be formed using lighter materials (including non-metals) in some applications. The middle material 334 can likewise be a middle electrode formed using various suitable metals such as, for example, aluminum, copper, molybdenum, tungsten, platinum, iridium, and/or other suitable metals. The middle material 334 can also be formed using lighter materials (including non-metals) in some applications. The middle material 332 is disposed between the piezoelectric film 342 and the piezoelectric film 344, and the middle material 334 is disposed between the piezoelectric film 344 and the piezoelectric film 346. The middle material 332 and the middle material 334 can be constructed such that the middle material 332 and the middle material 334 do not acoustically decouple the piezoelectric film 342, the piezoelectric film 344, and the piezoelectric film 346 (e.g., like in a CRF where decoupling layer(s) are included between piezoelectric layer(s)). The piezoelectric film 342, the piezoelectric film 344, and the piezoelectric film 346 instead can be tightly coupled acoustically to form a single resonator device with one series resonance and one parallel resonance. The composition and the thickness of the middle material 332 and the middle material 334 can be adjusted to ensure that the resonator device 300 has a Type II response.

The piezoelectric film 342, the piezoelectric film 344, and the piezoelectric film 346 can be formed using various suitable piezoelectric materials depending on the application. For example, the piezoelectric film 342 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 344 can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 346 can also be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 346 has a first polarity P₁, the piezoelectric film 344 has a second polarity P₂, and the piezoelectric film 342 has a third polarity P₃. The first polarity and the third polarity are in a first orientation and the second polarity is in a second orientation, where the first orientation is opposite the second orientation.

The first polarity, the second polarity, and/or the third polarity can be created in the piezoelectric film 342, the piezoelectric film 344, and/or the piezoelectric film 346, respectively, by doping the piezoelectric film 342, the piezoelectric film 344, and/or the piezoelectric film 346 with a dopant. For example, the piezoelectric film 342, the piezoelectric film 344, and the piezoelectric film 346 can all be deposited as M-polar, and then the piezoelectric film 344 can de doped with a suitable dopant to reverse the polarization of the piezoelectric film 344 to be N-polar. The dopant can be any of a variety of suitable dopants, such as, for example, silicon, germanium, magnesium, copper, aluminum, a combination of silicon and magnesium, a combination of magnesium with one or more additional elements, and/or other suitable dopants. The piezoelectric film 346 can be disposed between the top electrode 310 and the bottom electrode 320, the piezoelectric film 344 can be disposed between the piezoelectric film 346 and the top electrode 310, and the piezoelectric film 342 can be disposed between the piezoelectric film 344 and the top electrode 310.

The piezoelectric film 342, the piezoelectric film 344, and the piezoelectric film 346 can be symmetric (e.g., the same composition and thickness as measured between adjacent piezoelectric layers in the stack) or they can be asymmetric (e.g., different composition such as thickness and/or material properties such as acoustic velocity, piezoelectric constant, etc.) as long as they satisfy the condition that the polarity orientations are reversed relative to each other. In cases where the piezoelectric film 342, the piezoelectric film 344, and the piezoelectric film 346 are symmetric, the resonator device 300 can advantageously provide only the third overtone (TE3 mode). However, when the piezoelectric film 342, the piezoelectric film 344, and the piezoelectric film 346 are asymmetric, the resonator device 300 can provide the third overtone and associated advantages, but also may provide residual (parasitic) modes such as TE4, TE2, and/or TE1 overtones. The resonator device 300 can provide around three times the frequency of a single piezoelectric layer FBAR device with around the same active stack thickness.

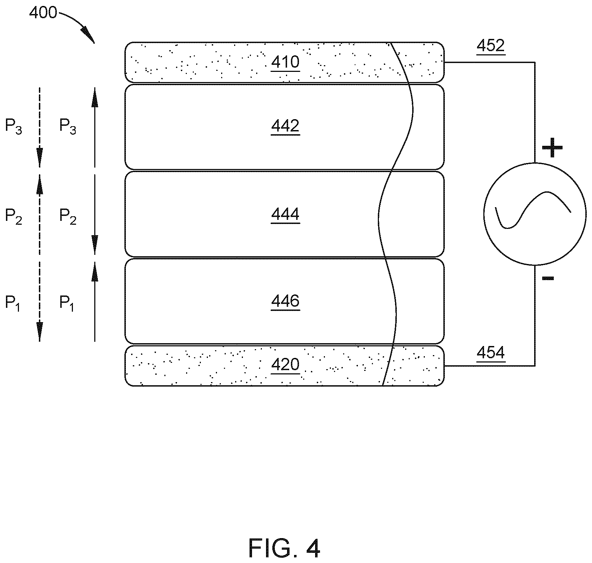

Referring to FIG. 4, a cross section illustrating another example resonator device 400 is shown, in accordance with some aspects of the disclosure. The resonator device 400 generally is similar to the resonator device 300. However, relative to the resonator device 300, the resonator device 400 does not include middle layers between piezo layers. Due to the absence of the middle layers, the resonator device 400 generally is a Type I resonator device instead of a Type II resonator device, and can provide advantages in different applications. The resonator device 400 can also be considered a TE3 device that includes a stack of layers. As illustrated in FIG. 4, the resonator device 400 includes a top electrode 410, a bottom electrode 420, a piezoelectric film 442, a piezoelectric film 444, and a piezoelectric film 446. The top electrode 410 can be coupled to an input signal 452 (e.g., an RF signal, etc.), and the bottom electrode 420 can then be coupled to a reference voltage 454 (i.e., the bottom electrode 420 can be grounded). These connections can also be reversed such that the top electrode 410 can be coupled to the reference voltage 454 and the bottom electrode 420 can be coupled to the input signal 452.

The top electrode 410 and the bottom electrode 420 can be formed using various suitable materials depending on the application. For example, the top electrode 410 can be formed using suitable metals such as, for example, aluminum, copper, molybdenum, tungsten, platinum, iridium, and/or other suitable metals. The bottom electrode 420 can likewise be formed using suitable metals such as, for example, aluminum, copper, molybdenum, tungsten, platinum, iridium, and/or other suitable metals. The top electrode 410 and/or the bottom electrode 420 can also be formed using lighter materials in some applications such as, for example, materials that are not necessarily metals. Notably, relative to alternative structures, only the bottom electrode 420 is grounded, and the top electrode 410 is then coupled to the input signal 452 (or the reverse). As a result, the piezoelectric film 442, the piezoelectric film 444, and the piezoelectric film 446 are not connected in parallel, but in series.

The piezoelectric film 442, the piezoelectric film 444, and the piezoelectric film 446 can be formed using various suitable piezoelectric materials depending on the application. For example, the piezoelectric film 442 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 444 can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 446 can also be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 446 has a first polarity P₁, the piezoelectric film 444 has a second polarity P₂, and the piezoelectric film 442 has a third polarity P₃. The first polarity and the third polarity are in a first orientation and the second polarity is in a second orientation, where the first orientation is opposite the second orientation.

The first polarity, the second polarity, and/or the third polarity can be created in the piezoelectric film 442, the piezoelectric film 444, and/or the piezoelectric film 446, respectively, by doping the piezoelectric film 442, the piezoelectric film 444, and/or the piezoelectric film 446 with a dopant. For example, the piezoelectric film 442, the piezoelectric film 444, and the piezoelectric film 446 can all be deposited as N-polar, and then the piezoelectric film 444 can de doped with a suitable dopant to reverse the polarization of the piezoelectric film 444 to be M-polar. The dopant can be any of a variety of suitable dopants, such as, for example, silicon, germanium, magnesium, copper, aluminum, a combination of silicon and magnesium, a combination of magnesium with one or more additional elements, and/or other suitable dopants. The piezoelectric film 446 can be disposed between the top electrode 410 and the bottom electrode 420, the piezoelectric film 444 can be disposed between the piezoelectric film 446 and the top electrode 410, and the piezoelectric film 442 can be disposed between the piezoelectric film 444 and the top electrode 410.

The piezoelectric film 442, the piezoelectric film 444, and the piezoelectric film 446 can be symmetric (e.g., the same composition and thickness as measured between adjacent piezoelectric layers in the stack) or they can be asymmetric (e.g., different composition such as thickness and/or material properties such as acoustic velocity, piezoelectric constant, etc.) as long as they satisfy the condition that the polarity orientations are reversed relative to each other. In cases where the piezoelectric film 442, the piezoelectric film 444, and the piezoelectric film 446 are symmetric, the resonator device 400 can advantageously provide only the third overtone (TE3 mode). However, when the piezoelectric film 442, the piezoelectric film 444, and the piezoelectric film 446 are asymmetric, the resonator device 400 can provide the third overtone and associated advantages, but also may provide residual (parasitic) modes such as TE4, TE2, and/or TE1 overtones. The resonator device 400 can provide around three times the frequency of a single piezoelectric layer FBAR device with around the same active stack thickness.

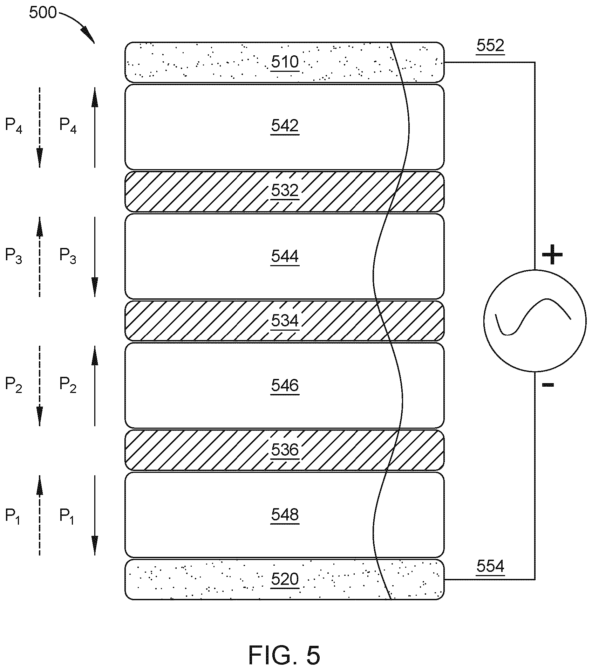

Referring to FIG. 5, a cross section illustrating another example resonator device 500 is shown, in accordance with some aspects of the disclosure. The resonator device 500 generally is similar to the resonator device 100. However, relative to the resonator device 100, the resonator device 500 includes four piezoelectric film layers instead of two piezoelectric film layers to provide added suitability for high frequency applications, for example. Accordingly, the resonator device 500 can be considered the fourth thickness extensional (TE4) mode with a polarization-switched bulk acoustic resonator device that includes a stack of layers. As illustrated in FIG. 5, the resonator device 500 includes a top electrode 510, a bottom electrode 520, a middle material 532, a middle material 534, a middle material 536, a piezoelectric film 542, a piezoelectric film 544, a piezoelectric film 546, and a piezoelectric film 548. The top electrode 510 can be coupled to an input signal 552 (e.g., an RF signal, etc.), and the bottom electrode 520 can then be coupled to a reference voltage 554 (i.e., the bottom electrode 520 can be grounded). These connections can also be reversed such that the top electrode 510 can be coupled to the reference voltage 554 and the bottom electrode 520 can be coupled to the input signal 552.

The top electrode 510 and the bottom electrode 520 can be formed using various suitable materials depending on the application. For example, the top electrode 510 can be formed using suitable metals such as, for example, aluminum, copper, molybdenum, tungsten, platinum, iridium, and/or other suitable metals. The bottom electrode 520 can likewise be formed using suitable metals such as, for example, aluminum, copper, molybdenum, tungsten, platinum, iridium, and/or other suitable metals. The top electrode 510 and/or the bottom electrode 520 can also be formed using lighter materials in some applications such as, for example, materials that are not necessarily metals. Notably, relative to alternative structures, only the bottom electrode 520 is grounded, and the top electrode 510 is then coupled to the input signal 552 (or the reverse). As a result, the piezoelectric film 542, the piezoelectric film 544, the piezoelectric film 546, and the piezoelectric film 548 are not connected in parallel, but in series.

The middle material 532, the middle material 534, and the middle material 536 can also be formed using various suitable materials depending on the application. For example, the middle material 532 can be a middle electrode formed using suitable metals such as, for example, aluminum, copper, molybdenum, tungsten, platinum, iridium, and/or other suitable metals. The middle material 532 can also be formed using lighter materials (including non-metals) in some applications. The middle material 534 can likewise be a middle electrode formed using suitable metals such as, for example, aluminum, copper, molybdenum, tungsten, platinum, iridium, and/or other suitable metals. The middle material 534 can also be formed using lighter materials (including non-metals) in some applications. The middle material 536 also can be a middle electrode formed using suitable metals such as, for example, aluminum, copper, molybdenum, tungsten, platinum, iridium, and/or other suitable metals. The middle material 536 likewise can be formed using lighter materials (including non-metals) in some applications.

The middle material 532 is disposed between the piezoelectric film 542 and the piezoelectric film 544, the middle material 534 is disposed between the piezoelectric film 544 and the piezoelectric film 546, and the middle material 536 is disposed between the piezoelectric film 546 and the piezoelectric film 548. The middle material 532, the middle material 534, and the middle material 536 can be constructed in a manner such that the middle material 532, the middle material 534, and the middle material 536 do not acoustically decouple the piezoelectric film 542, the piezoelectric film 544, the piezoelectric film 546, and the piezoelectric film 548 (e.g., like in a CRF where decoupling layer(s) are included between piezoelectric layer(s)). The piezoelectric film 542, the piezoelectric film 544, the piezoelectric film 546, and the piezoelectric film 548 instead can be tightly coupled acoustically to form a single resonator device with one series resonance and one parallel resonance. The composition and the thickness of the middle material 532, the middle material 534, and the middle material 536 can be adjusted to ensure that the resonator device 500 has a Type II response. The piezoelectric film 548 can be disposed between the top electrode 510 and the bottom electrode 520, the piezoelectric film 546 can be disposed between the piezoelectric film 548 and the top electrode 510, the piezoelectric film 544 can be disposed between the piezoelectric film 546 and the top electrode 510, and the piezoelectric film 542 can be disposed between the piezoelectric film 544 and the top electrode 510.

The piezoelectric film 542, the piezoelectric film 544, the piezoelectric film 546, and the piezoelectric film 548 can be formed using various suitable piezoelectric materials depending on the application. For example, the piezoelectric film 542 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 544 can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 546 also can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 548 also can be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 548 has a first polarity P₁, the piezoelectric film 546 has a second polarity P₂, the piezoelectric film 544 has a third polarity P₃, and the piezoelectric film 542 has a fourth polarity P₄. The first polarity and the third polarity are in a first orientation, the second polarity and the fourth polarity are in a second orientation, and the first orientation is opposite the second orientation.

The first polarity, the second polarity, the third polarity, and/or the fourth polarity can be created in the piezoelectric film 542, the piezoelectric film 544, the piezoelectric film 546, and/or the piezoelectric film 548, respectively, by doping the piezoelectric film 542, the piezoelectric film 544, the piezoelectric film 546, and/or the piezoelectric film 548 with a dopant. For example, the piezoelectric film 542, the piezoelectric film 544, the piezoelectric film 546, and the piezoelectric film 548 can all be deposited as M-polar, and then the piezoelectric film 542 and the piezoelectric film 546 can de doped with a suitable dopant to reverse the polarizations of the piezoelectric film 542 and the piezoelectric film 546 to be N-polar. The dopant can be any of a variety of suitable dopants, such as, for example, silicon, germanium, magnesium, copper, aluminum, a combination of silicon and magnesium, a combination of magnesium with one or more additional elements, and/or other suitable dopants.

The piezoelectric film 542, the piezoelectric film 544, the piezoelectric film 546, and the piezoelectric film 548 can be symmetric (e.g., the same composition and thickness as measured between adjacent piezoelectric layers in the stack) or asymmetric (e.g., different composition such as thickness and/or material properties such as acoustic velocity, piezoelectric constant, etc.) as long as they satisfy the condition that the polarity orientations are reversed relative to each other. In cases where the piezoelectric film 542, the piezoelectric film 544, the piezoelectric film 546, and the piezoelectric film 548 are symmetric, the resonator device 500 can advantageously provide only the fourth overtone (TE4 mode). However, when the piezoelectric film 542, the piezoelectric film 544, the piezoelectric film 546, and the piezoelectric film 548 are asymmetric, the resonator device 500 can provide the fourth overtone and associated advantages, but also may provide residual (parasitic) modes such as TE5 and/or TE3 overtones. The resonator device 500 can provide around four times the frequency of a single piezoelectric layer FBAR device with around the same active stack thickness.

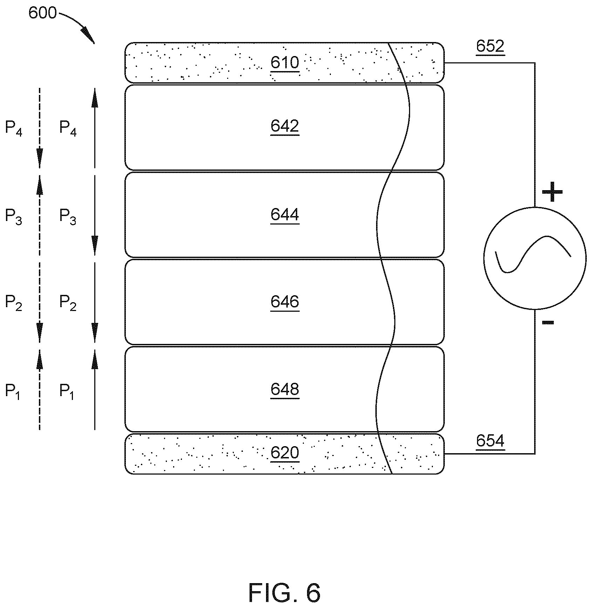

Referring to FIG. 6, a cross section illustrating another example resonator device 600 is shown, in accordance with some aspects of the disclosure. The resonator device 600 generally is similar to the resonator device 500. However, relative to the resonator device 500, the resonator device 600 does not include middle layers between piezo layers. Due to the absence of the middle layers, the resonator device 600 generally is a Type I resonator device instead of a Type II resonator device, and can provide advantages in different applications. The resonator device 600 can also be considered a TE4 device that includes a stack of layers. As illustrated in FIG. 6, the resonator device 600 includes a top electrode 610, a bottom electrode 620, a piezoelectric film 642, a piezoelectric film 644, a piezoelectric film 646, and a piezoelectric film 648. The top electrode 610 can be coupled to an input signal 652 (e.g., an RF signal, etc.), and the bottom electrode 620 can then be coupled to a reference voltage 654 (i.e., the bottom electrode 620 can be grounded). These connections can also be reversed such that the top electrode 610 can be coupled to the reference voltage 654 and the bottom electrode 620 can be coupled to the input signal 652.

The top electrode 610 and the bottom electrode 620 can be formed using various suitable materials depending on the application. For example, the top electrode 610 can be formed using suitable metals such as, for example, aluminum, copper, molybdenum, tungsten, platinum, iridium, and/or other suitable metals. The bottom electrode 620 can likewise be formed using suitable metals such as, for example, aluminum, copper, molybdenum, tungsten, platinum, iridium, and/or other suitable metals. The top electrode 610 and/or the bottom electrode 620 can also be formed using lighter materials in some applications such as, for example, materials that are not necessarily metals. Notably, relative to alternative structures, only the bottom electrode 620 is grounded, and the top electrode 610 is then coupled to the input signal 652 (or the reverse). As a result, the piezoelectric film 642, the piezoelectric film 644, the piezoelectric film 646, and the piezoelectric film 648 are not connected in parallel, but in series.

The piezoelectric film 642, the piezoelectric film 644, the piezoelectric film 646, and the piezoelectric film 648 can be formed using various suitable piezoelectric materials depending on the application. For example, the piezoelectric film 642 can be formed using aluminum nitride, scandium aluminum nitride, zinc oxide, lead zirconate titanate, barium strontium titanate, lithium tantalate, lithium niobate, and/or other suitable piezoelectric materials. Similarly, the piezoelectric film 644 can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 646 also can be formed using aluminum nitride, scandium aluminum nitride, zinc oxide, lead zirconate titanate, barium strontium titanate, lithium tantalate, lithium niobate, and/or other suitable piezoelectric materials. The piezoelectric film 648 also can be formed using aluminum nitride, scandium aluminum nitride, zinc oxide, lead zirconate titanate, barium strontium titanate, lithium tantalate, lithium niobate, and/or other suitable piezoelectric materials. As shown, the piezoelectric film 648 has a first polarity P₁, the piezoelectric film 646 has a second polarity P₂, the piezoelectric film 644 has a third polarity P₃, and the piezoelectric film 642 has a fourth polarity P₄. The first polarity and the third polarity are in a first orientation, the second polarity and the fourth polarity are in a second orientation, and the first orientation is opposite the second orientation.

The first polarity, the second polarity, the third polarity, and/or the fourth polarity can be created in the piezoelectric film 642, the piezoelectric film 644, the piezoelectric film 646, and/or the piezoelectric film 648, respectively, by doping the piezoelectric film 642, the piezoelectric film 644, the piezoelectric film 646, and/or the piezoelectric film 648 with a dopant. For example, the piezoelectric film 642, the piezoelectric film 644, the piezoelectric film 646, and the piezoelectric film 648 can all be deposited as N-polar, and then the piezoelectric film 642 and the piezoelectric film 646 can de doped with a suitable dopant to reverse the polarizations of the piezoelectric film 642 and the piezoelectric film 646 to be M-polar. The dopant can be any of a variety of suitable dopants, such as, for example, silicon, germanium, magnesium, copper, aluminum, a combination of silicon and magnesium, a combination of magnesium with one or more additional elements, and/or other suitable dopants. The piezoelectric film 648 can be disposed between the top electrode 610 and the bottom electrode 620, the piezoelectric film 646 can be disposed between the piezoelectric film 648 and the top electrode 610, the piezoelectric film 644 can be disposed between the piezoelectric film 646 and the top electrode 610, and the piezoelectric film 642 can be disposed between the piezoelectric film 644 and the top electrode 610.

The piezoelectric film 642, the piezoelectric film 644, the piezoelectric film 646, and the piezoelectric film 648 can be symmetric (e.g., the same composition and thickness as measured between adjacent piezoelectric layers in the stack) or asymmetric (e.g., different composition such as thickness and/or material properties such as acoustic velocity, piezoelectric constant, etc.) as long as they satisfy the condition that the polarity orientations are reversed relative to each other. In cases where the piezoelectric film 642, the piezoelectric film 644, the piezoelectric film 646, and the piezoelectric film 648 are symmetric, the resonator device 600 can advantageously provide only the fourth overtone (TE4 mode). However, when the piezoelectric film 642, the piezoelectric film 644, the piezoelectric film 646, and the piezoelectric film 648 are asymmetric, the resonator device 600 can provide the fourth overtone and associated advantages, but also may provide residual (parasitic) modes such as TE5 and/or TE3 overtones. The resonator device 600 can provide around four times the frequency of a single piezoelectric layer FBAR device with around the same active stack thickness.

## Claims

1. A resonator device, comprising:
a first electrode;
a second electrode;
a first piezoelectric film disposed between the first electrode and the second electrode, the first piezoelectric film comprising a first polarization in a first orientation; and
a second piezoelectric film disposed between the first piezoelectric film and the first electrode, the second piezoelectric film comprising a second polarization in a second orientation, the second orientation being opposite of the first orientation.

2. The resonator device of claim 1, wherein the second piezoelectric film comprises a dopant providing the second polarization in the second orientation.

3. The resonator device of claim 2, wherein both the first piezoelectric film and the second piezoelectric film comprise aluminum nitride or scandium aluminum nitride
and/or
wherein the dopant comprises silicon, magnesium, or a combination of silicon and magnesium.

4. The resonator device of one of the previous claims, comprising a middle material disposed between the first piezoelectric film and the second piezoelectric film.

5. The resonator device of one of the previous claims, wherein:
a) the first piezoelectric film comprises a first piezoelectric constant;
the second piezoelectric film comprises a second piezoelectric constant; and
the first piezoelectric constant is different from the second piezoelectric constant and/or
b) the first piezoelectric film comprises a first acoustic velocity;
the second piezoelectric film comprises a second acoustic velocity; and
the first acoustic velocity is different from the second acoustic velocity.

6. A resonator device, comprising:
a first electrode;
a second electrode;
a first piezoelectric film disposed between the first electrode and the second electrode, the first piezoelectric film comprising a first polarization in a first orientation;
a second piezoelectric film disposed between the first piezoelectric film and the first electrode, the second piezoelectric film comprising a second polarization in a second orientation, the second orientation being opposite of the first orientation; and
a third piezoelectric film disposed between the second piezoelectric film and the first electrode, the second piezoelectric film comprising a third polarization in the first orientation.

7. The resonator device of claim 6, wherein:
the second piezoelectric film comprises a dopant providing the second polarization in the second orientation; and
the dopant comprises silicon, magnesium, or a combination of silicon and magnesium.

8. The resonator device of claims 6 or 7, wherein the first piezoelectric film and the third piezoelectric film comprise a dopant providing the first polarization in the first orientation and the third polarization in the first orientation.

9. The resonator device of one of claims 6 to 8, comprising:
a first middle material that is disposed between the first piezoelectric film and the second piezoelectric film; and
a second middle material that is disposed between the second piezoelectric film and the third piezoelectric film.

10. The resonator device of one of the previous claims, wherein:
the first piezoelectric film comprises a first thickness;
the second piezoelectric film comprises a second thickness; and
the first thickness is different from the second thickness.

11. A resonator device, comprising:
a first electrode;
a second electrode;
a first piezoelectric film disposed between the first electrode and the second electrode, the first piezoelectric film comprising a first polarization in a first orientation;
a second piezoelectric film disposed between the first piezoelectric film and the first electrode, the second piezoelectric film comprising a second polarization in a second orientation, the second orientation being opposite of the first orientation;
a third piezoelectric film disposed between the second piezoelectric film and the first electrode, the second piezoelectric film comprising a third polarization in the first orientation; and
a fourth piezoelectric film disposed between the third piezoelectric film and the first electrode, the fourth piezoelectric film comprising a fourth polarization in the second orientation.

12. The resonator device of claim 11, wherein:
the first piezoelectric film and the third piezoelectric film comprise a dopant providing the first polarization in the first orientation and the third polarization in the first orientation; and
the dopant comprises silicon, magnesium, or a combination of silicon and magnesium.

13. The resonator device of claims 11 or 12, comprising:
a first middle material that is disposed between the first piezoelectric film and the second piezoelectric film;
a second middle material that is disposed between the second piezoelectric film and the third piezoelectric film; and
a third middle material that is disposed between the third piezoelectric film and the fourth piezoelectric film.

14. The resonator device of one of the previous claims, wherein the first electrode is coupled to an input signal and the second electrode is grounded.

15. The resonator device of one of claims 11 to 14, wherein:
the first piezoelectric film comprises a first thickness, a first piezoelectric constant, and a first acoustic velocity;
the second piezoelectric film comprises a second thickness, a second piezoelectric constant, and a second acoustic velocity; and
the first thickness is different from the second thickness, the first piezoelectric constant is different from the second piezoelectric constant, or the first acoustic velocity is different from the second acoustic velocity.
